# EUROPEAN PATENT APPLICATION

(11) **EP 4 220 672 A1**
(43) Date of publication of application: **02.08.2023**
(21) Application number: 22305082.4
(22) Date of filing: 26.01.2022
(51) Int. Cl.: H01F 38/08, H01F 3/12, H01F 17/06, H01F 3/10, H01F 27/02, H01F 27/40

(54) **A DUAL MODE ELECTROMAGNETIC INTERFERENCE FILTER USING MAGNETIC COMPOSITE MATERIAL AND PROCESS FOR MAKING THE SAME**

(71) Applicant: Mitsubishi Electric R & D Centre Europe B.V., 1119 NS Schiphol Rijk (NL); MITSUBISHI ELECTRIC CORPORATION, Chiyoda-ku Tokyo 100-8310 (JP)
(72) Inventor: MORAND, Julien, 35708 Rennes Cedex (FR); NAGASAWA, Shinobu, Tokyo, 100-8310 (JP); LEFEVRE, Guillaume, 35708 Rennes Cedex (FR)
(74) Representative: Cabinet Le Guen Maillet

(57) **Abstract**

The present invention concerns a dual mode electromagnetic interference filter comprising a first magnetic core and windings that are wound around the first magnetic core, wherein the dual mode electromagnetic interference filter further comprises a magnetic composite material moulded at the vicinity of the windings and an insulation layer that insulates each turn of the windings from the magnetic composite material.

## Description

### TECHNICAL FIELD

The present invention relates generally to a dual mode electromagnetic interference filter using magnetic composite material and process for making the same.

### RELATED ART

Power electronic converters are sources of electromagnetic interference. In most applications, conducted emitted perturbations are restricted to a certain level by standard committees. To comply with these various standards, Electro Magnetic Interference (EMI) filters are added on the input and output ports of the power converter to filter both Common Mode (CM) and Differential Mode (DM) current.

A general trend in power electronics is to increase the density of converters. This trend is driven by application specific requirements. As an example, in electro mobility applications, the increase in power density allows to allocate more space to the passenger compartment and the saved weight helps to extend the range or reduce CO² emission in the case of Hybrid Electric Vehicle (HEV).

In consumer electronic applications, a more compact power converter is the key to miniaturization as it can clearly be seen in smartphone or laptop chargers. The continuous increase in the switching frequency and the remarkable progress in the power switches technology has led to a massive reduction in the size of the power converters.

Unfortunately, the Electro Magnetic Compatibility (EMC) filter size is following an opposite trend. Indeed, passive components within the switching cell are storing less energy with the frequency increase.

The level of conducted emissions, particularly for the common mode, is raised due to the higher level of the voltage variation over the time dv/dt that is converted into an important common mode current thought parasitic capacitance brought by Wide Band Gap (WBG) devices. In addition, the higher switching frequency is extending the frequency range of the common mode perturbation.

Thus, to reach the desired attenuation level, the value of the common mode inductance is generally increased leading to a bigger and heavier component.

In current EMI filters, the windings of the common mode choke present leakage flux inherent to its construction. Electrically speaking this leakage flux can be modelled as added chokes in series with the common mode choke contributing to the differential noise rejection in the filter. However, the inductance value of these components is limited by the winding structure, the core geometry and the characteristics of the core material.

Existing solutions for dual mode inductor are mostly relying on a high permeability magnetic core with an air gap for the differential mode integration within a common mode choke.

### SUMMARY OF THE INVENTION

The present invention aims to provide a dual mode electromagnetic interference filter using magnetic composite material moulded at the vicinity of the windings to reduce the reluctance of the leakage path and therefore increase the differential mode inductance.

To that end, the present invention concerns a dual mode electromagnetic interference filter comprising a first magnetic core and windings that are wound around the first magnetic core characterised in that the dual mode electromagnetic interference filter further comprises:
- a magnetic composite material moulded at the vicinity of the windings,
- an insulation layer that insulates each turn of the windings from the magnetic composite material.

Thus, the conformability of the magnetic composite material in its uncured state allows to completely fill the volume around each turn. The void-free feature of this material allows to increase drastically the leakage flux of each winding resulting in an increased differential mode inductance. The insulation layer prevents the magnetic composite material to be inserted in the space located in between each turn of the windings and keeps the turn-to-turn capacitance to its minimum value.

According to a particular feature, the dual mode electromagnetic interference filter further comprises a conductive material part placed on the magnetic composite material.

Thus, a built-in common mode capacitor can be built without adding any additional part and keeping the same footprint.

According to a particular feature, the conductive material part is a heat sink.

Thus, the heat generating by the first magnetic core losses and the copper losses can be easily extracted from the component while combining the common mode capacitor feature. Indeed, most heatsinks are made of electrically conductive material such as copper or aluminium brass or silver or carbone. The heatsink also acts as one electrode of the common mode capacitor.

According to a particular feature, the magnetic composite material is moulded in the inner space of the first magnetic core.

Thus, the global volume of the component is identical to a classical common mode inductance with a higher differential mode inductance.

According to a particular feature, the magnetic composite material is moulded only around the external side of the first magnetic core.

Thus, the thickness of required magnetic material is reduced compared to the inner filling for an equivalent differential mode inductance.

According to a particular feature, the magnetic composite material is moulded on the top of the first magnetic core.

Thus, the footprint of the dual mode electromagnetic interference filter is identical to a common mode inductance with a higher differential mode inductance.

According to a particular feature, the magnetic composite material is moulded all around the first magnetic core and in the inner space of the first magnetic core.

The present invention concerns also a method for manufacturing a dual mode electromagnetic interference filter, characterized in that the method comprises the steps of:
- selecting a first magnetic core that fits the requirements on the common mode filtering and wounding windings around the first magnetic core,
- insulating each turn of the windings,
- placing the first magnetic core in a mold,
- forming a magnetic composite material using uniaxial die pressing or injection molding technic.

According to a particular feature, the method comprises further step of placing a conductive material part on the magnetic composite material.

### BRIEF DESCRIPTION OF THE DRAWINGS

The characteristics of the invention will emerge more clearly from a reading of the following description of example embodiments, the said description being produced with reference to the accompanying drawings, among which:
Fig. 1 represents an example of an electric model of a dual mode electromagnetic compatibility filter according to the present invention;
Fig. 2 represents a first example of realization of a dual mode electromagnetic compatibility filter according to the present invention;
Fig. 3 represents a second example of realization of a dual mode electromagnetic compatibility filter according to the present invention;
Fig. 4 represents a third example of realization of a dual mode electromagnetic compatibility filter according to the present invention;
Fig. 5 represents a fourth example of realization of a dual mode electromagnetic compatibility filter according to the present invention;
Fig. 6 represents a fifth example of realization of a dual mode electromagnetic compatibility filter according to the present invention;
Fig. 7 represents an architecture of a system for making a dual mode electromagnetic compatibility filter using magnetic composite material;
Fig. 8 represents an algorithm for making a dual mode electromagnetic compatibility filter using magnetic composite material.

### DESCRIPTION

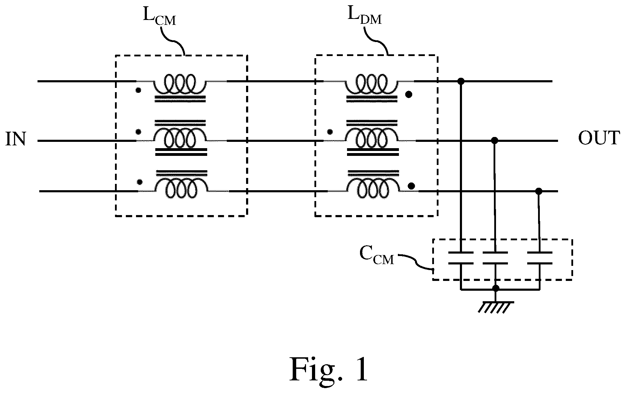

**Fig. 1** represents an example of an electric model of a dual mode electromagnetic compatibility filter according to the present invention.

The example of Fig. 1 is an electric model of a three-phase electromagnetic compatibility filter. The three-phase electromagnetic compatibility filter is a dual mode filter that filters the common mode and the differential mode.

The present invention is also applicable for single-phase or poly-phases like, for example, for sensor and injector windings.

The dual mode electromagnetic compatibility filter is composed of three windings that are wounded around a first magnetic core with a high relative permeability in the 2000 to 30000 range that create a common mode inductance.

The windings of the common mode inductance L_{CM} present leakage flux inherent to its construction. The leakage flux can be modelled as added inductors in series L_{DM} with the common mode inductor contributing to the differential noise rejection in the filter.

According to the invention, the differential mode filtering is enabled by a magnetic composite material that is placed at the vicinity of the windings. The windings WD1, WD2 and WD3 are in contact with an insulation layer and the insulation layer is in contact with the magnetic composite material SMC1.

More precisely, the magnetic composite material is over-moulded around the existing windings, the insulation layer and the first magnetic core.

Each turn of the windings is electrically insulated with the magnetic composite material by the insulation layer using for example a wound tape, an enamel coating, a vinyl or PVC sheath. In another implementation, the insulation layer can be done by a part made of vertical fences placed between each turn to fill the space between each turn and prevent insertion of the magnetic composite material.

Optionally, an electrically conducting part may be connected to the ground and is in contact with the magnetic composite material. The windings, the insulation layer, the magnetic composite material and the electrically conducting part form a common mode capacitor C_{CM}.

For example, the electrically conducting part is made of aluminium, copper, brass, silver or carbone.

The magnetic composite material is for example a Soft Magnetic Composite (SMC). It is a mix of a magnetic powder such as Iron based powder, Nickel based or Zinc based powder and a binder that is fulfilling two requirements: to isolate each magnetic particle to each other to limit the circulation of eddy current and to restrict the losses associated to this phenomenon and to mechanically bind the particles giving the core sufficient strength to be manipulated and integrated in the application.

In addition, the magnetic composite material particle approach is distributing the air gap into the whole core's volume. This distribution is helping to lower the losses due the fringing effect and a more homogeneous losses distribution can be obtained. Depending on the binder to active material ratio, the equivalent relative permeability of the mixture can be adjusted from ten to a few hundreds.

The windings may be connected to a power converter in such a way that the normal mode current(s) cancelled each other out. In the case of more than two windings (polyphase), the sum of normal mode currents should be equal to zero. Depending on the required differential mode inductance value and the cooling configuration of the electromagnetic compatibility filter, the inner space, the outer space including top, bottom and sides are filed with the magnetic composite material. When containing ferrite base magnetic powder (NiMn, ZnMn), the relative permittivity of the magnetic composite material is multiple times higher than air (at least 20). Therefore, with the presence of the magnetic composite material, the turn-to-turn capacitance of the windings will increase and consequently decrease the usable bandwidth of the common mode inductor by decreasing the resonant frequency.

In the other hand, the capacitive coupling between phases (phase-to-phase capacitance) is higher which improves the differential mode rejection. The increase in turn-to-turn capacitance can be mitigated by adding a layer of an insulated material around the windings or by placing separator made of a dielectric material with a low permittivity instead of the magnetic material. In order to create a built-in common mode capacitor C_{CM}, a conductive part, typically a copper or aluminium brass, silver or carbone plate connected to the ground is placed in the vicinity of each winding, the conductive parts and the windings being the two electrodes of the capacitor and the SMC material is the dielectric material. The thickness of the magnetic composite material is then selected to offer the best trade-off between the gain in common mode capacitance and the differential mode inductance.

The type of the first magnetic core shape is preferably a toroid (ring core) but can also be applicable to C-shape, U-shape or E-shape cores.

The first magnetic core may be a MnZn ferrite core, a NiZn ferrite core, a Nanocrystalline core, an Amorphous core or a Dust core.

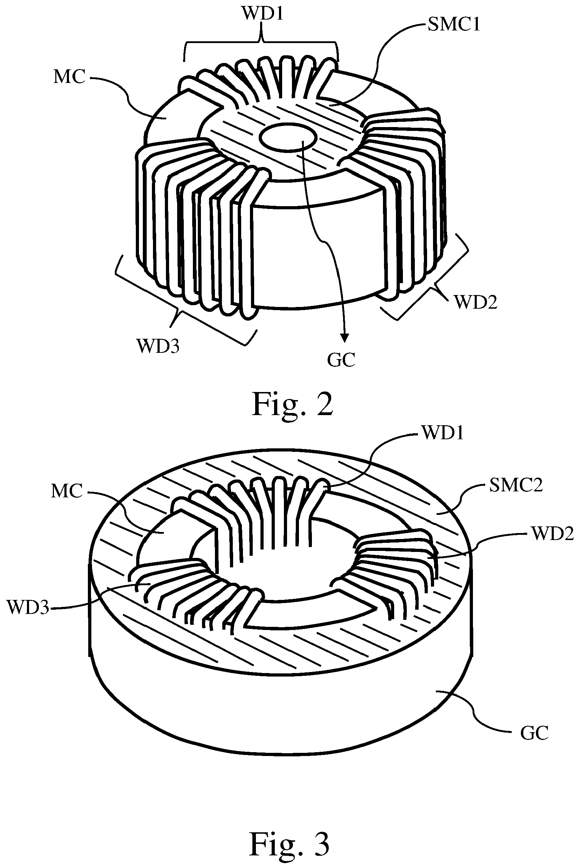

**Fig. 2** represents a first example of realization of a dual mode electromagnetic compatibility filter according to the present invention.

The electromagnetic compatibility filter is composed, for example, of three windings WD1, WD2 and WD3 that are wounded around the first magnetic core MC with a high relative permeability that creates the common mode inductance L_{CM}.

The first magnetic core MC is in the example of Fig. 2, a toroid.

According to the first example of realization of the invention, the differential mode filtering is enabled by a magnetic composite material SMC1 that is located in the vicinity of the windings. More precisely, the magnetic composite material SMC1 is located in the inner space of the first magnetic core MC.

The windings are electrically insulated with the magnetic composite material SMC1 by an insulation layer not shown in Fig. 2.

For example, the insulation is a wound tape, an enamel coating, a vinyl or PVC sheath. In another implementation, the insulation layer can be done by a part made of vertical fences placed between each turn to fill the space between each turn and prevent insertion of the magnetic composite material.

The magnetic composite material SMC1 is located in the vicinity of the windings as the windings WD1, WD2 and WD3 are in contact with the insulation layer and the insulation layer is in contact with the magnetic composite material SMC1.

Optionally, an electrically conducting part GC, connected to the ground, is in contact with the magnetic composite material SMC1. The windings, the insulation layer, the magnetic composite material SMC1 and the electrically conducting part form the common mode capacitor C_{CM}. The electrically conduction part GC has a cylinder shape. For example, the electrically conducting part is made of aluminium, copper, brass, silver or carbone.

The magnetic composite material is for example a Soft Magnetic Composite.

**Fig. 3** represents a second example of realization of a dual mode electromagnetic compatibility filter according to the present invention.

The electromagnetic compatibility filter is composed of three windings WD1, WD2 and WD3 that are wounded around the first magnetic core MC with a high relative permeability that creates the common mode inductance L_{CM}.

The first magnetic core is in the example of Fig. 3, a toroid.

According to the second example of realization of the invention, the differential mode filtering is enabled by the magnetic composite material SMC2 that is located in the vicinity of the windings. More precisely, the magnetic composite material SMC2 is located on outer space of the first magnetic core MC, more precisely only around the external side of the first magnetic core MC.

The windings are electrically insulated with the magnetic composite material by an insulation layer not shown in Fig. 3.

For example, the insulation is a wound tape, an enamel coating, a vinyl or PVC sheath. In another implementation, the insulation layer can be done by a part made of vertical fences placed between each turn to fill the space between each turn and prevent insertion of the magnetic composite material.

The magnetic composite material SMC2 is located in the vicinity of the windings as the windings WD1, WD2 and WD3 are in contact with the insulation layer and the insulation layer is in contact with the magnetic composite material SMC2.

Optionally, the electrically conducting part GC, connected to the ground, is in contact with the magnetic composite material SMC2. The windings, the insulation layer, the magnetic composite material SMC2 and the electrically conducting part GC form the common mode capacitor C_{CM}.

For example, the electrically conducting part is made of aluminium, copper, brass, silver or carbone.

The magnetic composite material is for example a Soft Magnetic Composite.

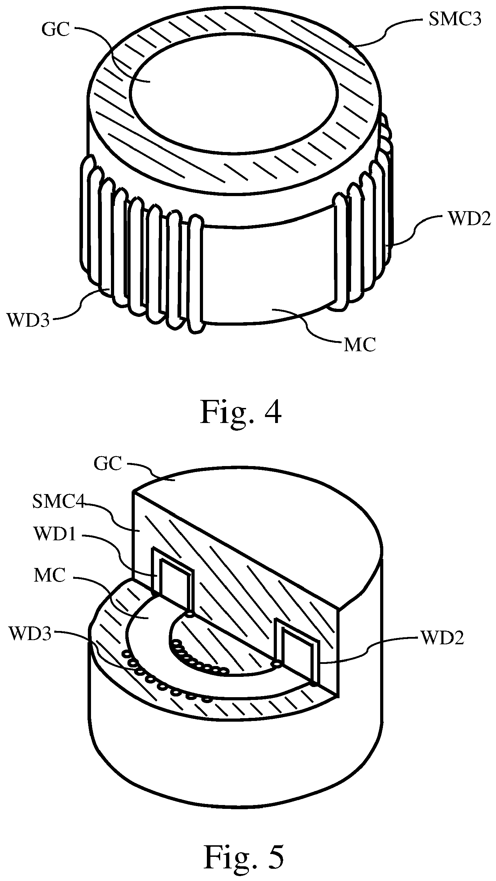

**Fig. 4** represents a third example of realization of an electromagnetic compatibility filter according to the present invention.

The electromagnetic compatibility filter is composed of three windings WD1, WD2 and WD3 that are wounded around the first magnetic core MC with a high relative permeability that creates the common mode inductance L_{CM}.

The first magnetic core is in the example of Fig. 4, a toroid.

According to the third example of realization of the invention, the differential mode filtering is enabled by the magnetic composite material SMC3 that is located in the vicinity of the windings. More precisely, magnetic composite material SMC3 is located at the outer space of the first magnetic core MC, more precisely on the top of the first magnetic core MC.

The windings are electrically insulated with the magnetic composite material by an insulation layer using not shown in Fig. 4. For example, an insulation is a wound tape, an enamel coating, a vinyl or PVC sheath. In another implementation, the insulation layer can be done by a part made of vertical fences placed between each turn to fill the space between each turn and prevent insertion of the magnetic composite material.

The magnetic composite material SMC3 is located in the vicinity of the windings as the windings WD1, WD2 and WD3 are in contact with the insulation layer and the insulation layer is in contact with the magnetic composite material SMC3.

Optionally, the electrically conducting part GC, connected to the ground is in contact with the magnetic composite material SMC3. The windings, the insulation layer, the magnetic composite material SMC3 and the electrically conducting part GC form the common mode capacitor C_{CM}.

For example, the electrically conducting part is made of aluminium, copper, brass, silver or carbone.

The magnetic composite material is for example a Soft Magnetic Composite.

**Fig. 5** represents a fourth example of realization of an electromagnetic compatibility filter according to the present invention.

The electromagnetic compatibility filter is composed of three windings WD1, WD2 and WD3 that are wounded around the first magnetic core MC with a high relative permeability that creates the common mode inductance L_{CM}.

The first magnetic core is in the example of Fig. 5, a toroid.

According to the fourth example of realization of the invention, the differential mode filtering is enabled by the magnetic composite material SMC4 that is located in the vicinity of the windings. More precisely, the magnetic composite material SMC4 is located at the outer space of the first magnetic core MC, more precisely around the first magnetic core MC and in the inner space of the first magnetic core MC.

The windings are electrically insulated with the magnetic composite material by an insulation layer not shown in Fig. 5.

For example, the insulation is a wound tape, an enamel coating, a vinyl or PVC sheath. In another implementation, the insulation layer can be done by a part made of vertical fences placed between each turn to fill the space between each turn and prevent insertion of the magnetic composite material.

The magnetic composite material SMC4 is located in the vicinity of the windings as the windings WD1, WD2 and WD3 are in contact with the insulation layer and the insulation layer is in contact with the magnetic composite material SMC4.

Optionally, the electrically conducting part GC, connected to the ground, is in contact with the magnetic composite material SMC4. The windings, the insulation layer, the magnetic composite material SMC4 and the electrically conducting part GC form the common mode capacitor C_{CM}.

For example, the electrically conducting part is made of aluminium, copper, brass, silver or carbone.

The magnetic composite material is for example a Soft Magnetic Composite.

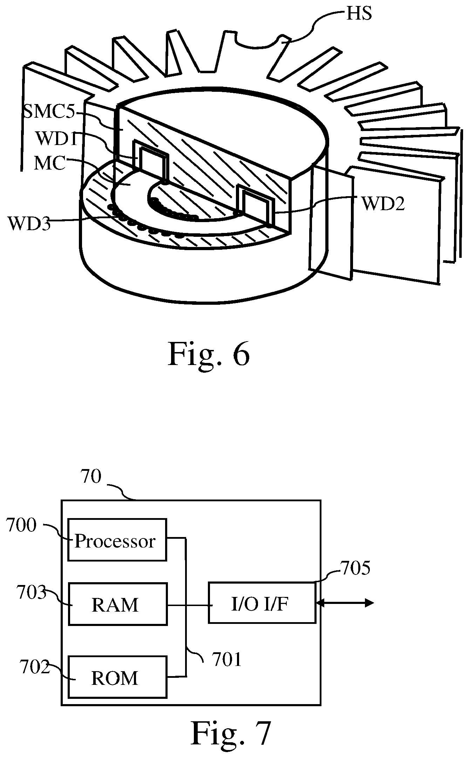

**Fig. 6** represents a fifth example of realization of an electromagnetic compatibility filter according to the present invention.

The electromagnetic compatibility filter is composed of three windings WD1, WD2 and WD3 that are wounded around the first magnetic core MC with a high relative permeability that creates the common mode inductance L_{CM}.

The first magnetic core MC is in the example of Fig. 6, a toroid.

According to the fifth example of realization of the invention, the differential mode filtering is enabled by a magnetic composite material SMC5 that is located in the vicinity of the windings. More precisely, the magnetic composite material SMC5 is located at the outer space of the first magnetic core MC, more precisely around the first magnetic core MC and in the inner space of the first magnetic core MC.

In a variant, the magnetic composite material SMC5 is located only around the external side of the first magnetic core MC and in the inner space of the first magnetic core MC.

In other variants, the magnetic composite material SMC5 is located only around the external side of the first magnetic core MC, in the inner space of the first magnetic core MC and on the top and/or bottom of the first magnetic core MC.

The windings are electrically insulated with the magnetic composite material SMC1 by an insulation layer not shown in Fig. 6.

For example, the insulation is a wound tape, an enamel coating, a vinyl or PVC sheath. In another implementation, the insulation layer can be done by a part made of vertical fences placed between each turn to fill the space between each turn and prevent insertion of the magnetic composite material.

The magnetic composite material SMC5 is located in the vicinity of the windings as the windings WD1, WD2 and WD3 are in contact with the insulation layer and the insulation layer is in contact with the magnetic composite material SMC5.

An electrically conducting part HS, connected to the ground, is electrically in contact with the magnetic composite material SMC5. The electrically conducting part is a heat sink. The windings, the insulation layer, the magnetic composite material SMC5 and the electrically conducting part HS form the common mode capacitor C_{CM}.

The magnetic composite material is for example a Soft Magnetic Composite.

**Fig. 7** represents an architecture of a system for making a dual mode electromagnetic compatibility filter using magnetic composite material.

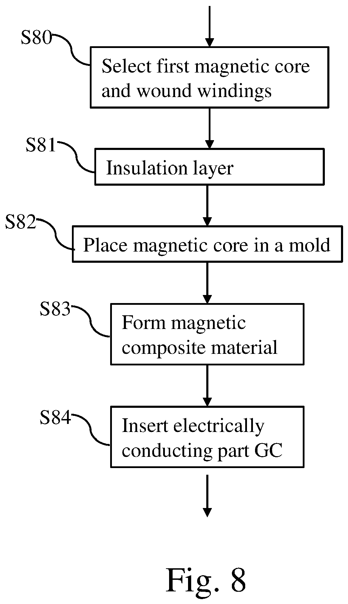

The system 70 has, for example, an architecture based on components connected by a bus 701 and a processor 700 controlled by a program as disclosed in Fig. 8.

The bus 701 links the processor 700 to a read only memory ROM 702, a random access memory RAM 703, an input output I/O IF interface 705.

The input output I/O IF interface 705 enables the control of the different apparatus that are used to produce dual mode electromagnetic compatibility filters.

The memory 703 contains registers intended to receive variables and the instructions of the program related to the algorithm as disclosed in Fig. 8.

The read-only memory, or possibly a Flash memory 702, contains instructions of the programs related to the algorithm as disclosed in Fig. 8, when the system 70 is powered on, that are loaded to the random access memory 703. Alternatively, the program may also be executed directly from the ROM memory 702.

The system 70 may be implemented in software by execution of a set of instructions or program by a programmable computing machine, such as a PC (*Personal Computer*)*,* a DSP (*Digital Signal Processor*) or a microcontroller; or else implemented in hardware by a machine or a dedicated component, such as an FPGA (*Field-Programmable Gate Array*) or an ASIC (*Application-Specific Integrated Circuit*)*.*

In other words, the system 70 includes circuitry, or a device including circuitry, causing the system 70 to perform the program related to the algorithm as disclosed in Fig. 8.

**Fig. 8** represents an algorithm for making a dual mode electromagnetic compatibility filter using magnetic composite material.

At step S80, a first magnetic core is selected to fit the requirements on the common mode filtering. The windings corresponding to the numbers of phases are wounded around the core in a classical manner.

At step S81, an insulation layer is deposited around each turn of each winding.

For example, the insulation is a wound tape, an enamel coating, a vinyl or PVC sheath. In another implementation, the insulation layer can be done by a part made of vertical fences placed between each turn to fill the space between each turn and prevent insertion of the magnetic composite material.

At step S82, the obtained part is then placed in a mold that will ensure a given section of a magnetic composite material, like for example a soft magnetic composite material, all over the windings. One possible molding configuration is only the inner volume of the core filled by the magnetic compound. One other possible configuration is only the outer volume of the core filled with the magnetic compound. One other possible configuration is the inner and outer volume filled with the magnetic compound. One other possible solution is the core and windings fully potted in the magnetic material. Optionally, parts made of conductive material can be placed in the vicinity of each windings to realize distributed CM capacitors thanks to the high permittivity of the mixture. The value of the capacitor is dependent on the distance between each turn of the windings and the other electrode (plate).

At step S83, the magnetic composite material is formed using uniaxial die pressing or injection molding technic depending on the viscosity of the mixture. A high mixture ratio goes along a higher relative permeability of the magnetic composite material that may lead to a local magnetic saturation of the common mode magnetic core. The volume fraction is consequently a design parameter.

At an optional step S84, conductive material parts can be placed on the magnetic composite material to make additional common mode capacitors.

Naturally, many modifications can be made to the embodiments of the invention described above without departing from the scope of the present invention.

## Claims

1. A dual mode electromagnetic interference filter comprising a first magnetic core and windings that are wound around the first magnetic core **characterised in that** the dual mode electromagnetic interference filter further comprises:
- a magnetic composite material moulded at the vicinity of the windings,
- an insulation layer that insulates each turn of the windings from the magnetic composite material.

2. The dual mode electromagnetic interference filter according to claim 1, **characterized in that** the dual mode electromagnetic interference filter further comprises a conductive material part placed on the magnetic composite material.

3. The dual mode electromagnetic interference filter according to claim 2, **characterized in that** the conductive material part is a heat sink.

4. The dual mode electromagnetic interference filter according to claim 1 or 2, **characterized in that** the magnetic composite material is moulded in the inner space of the first magnetic core.

5. The dual mode electromagnetic interference filter according to claim 1 or 2, **characterized in that** the magnetic composite material is moulded only around the external side of the first magnetic core.

6. The dual mode electromagnetic interference filter according to claim 1 or 2, **characterized in that** the magnetic composite material is moulded on the top of the first magnetic core.

7. The dual mode electromagnetic interference filter according to claim 1 or 2, **characterized in that** the magnetic composite material is moulded all around the first magnetic core and in the inner space of the first magnetic core.

8. A method for manufacturing a dual mode electromagnetic interference filter, **characterized in that** the method comprises the steps of:
- selecting a first magnetic core that fits the requirements on the common mode filtering and wounding windings around the first magnetic core,
- insulating each turn of the windings,
- placing the first magnetic core in a mold,
- forming a magnetic composite material using uniaxial die pressing or injection molding technic.

9. The method according to claim 7, **characterized in that** the method comprises further step of placing a conductive material part on the magnetic composite material.
